# EUROPÄISCHE PATENTSCHRIFT

(11) **EP 1 625 243 B1**
(45) Veröffentlichungstag und Bekanntmachung des Hinweises auf die Patenterteilung: **04.07.2012**
(21) Anmeldenummer: 04721543.9
(22) Anmeldetag: 18.03.2004
(51) Int. Cl.: C23C 16/46, C23C 16/448, C23C 16/458

(54) **CVD-BESCHICHTUNGSVORRICHTUNG**
CVD COATING DEVICE
DISPOSITIF DE REVETEMENT CVD

(30) Priorität: 22.05.2003 DE 10323085
(43) Veröffentlichungstag der Anmeldung: 15.02.2006
(73) Patentinhaber: Aixtron SE, 52134 Herzogenrath (DE)
(72) Erfinder: KÄPPELER, Johannes, 52146 Würselen (DE)
(74) Vertreter: Grundmann, Dirk
(86) Internationale Anmeldenummer: PCT/EP2004/050325
(87) Internationale Veröffentlichungsnummer: WO 2004/104265

(56) Entgegenhaltungen:
- DE-A- 10 043 600
- US-A- 6 001 183
- PATENT ABSTRACTS OF JAPAN Bd. 2002, Nr. 09, 4. September 2002 (2002-09-04) & JP 2002 146540 A (EBARA CORP; SUKEGAWA ELECTRIC CO LTD), 22. Mai 2002 (2002-05-22)

## Beschreibung

Die Erfindung betrifft eine Vorrichtung gemäß Gattungsbegriff des Anspruches 1.

Eine derartige Vorrichtung zum Abscheiden insbesondere kristalliner Schichten auf einem oder mehreren, insbesondere kristallinen Substraten beschreibt die US 6,001,183, bei der auf einer Trägerplatte ein Substrathalter aufliegt, der auf seiner Unterseite Aussparungen aufweist. Er besitzt eine zentrale Aussparung, um die die Substrate angeordnet sind und er besitzt eine periphere Aussparung, die stromabwärts der Substrate angeordnet ist. Mit dieser Horizontalfuge soll der Wärmetransport von einem unterhalb der Trägerplatte angeordneten Heizung zur Substrathalteroberseite beeinflusst werden. In weiteren Ausführungsbeispielen beschreibt dieser Druckschrift auch unterhalb des Substrates angeordnete Horizontalfugen, deren Fugenhöhe örtlich verschieden ist.

Die JP 2002-146540 A beschreibt einen auf einer von zwei Scheiben gebildeten Heizung aufliegenden Substrathalter, wobei unterhalb des Substrates eine Horizontalfuge vorgesehen ist.

Die DE 100 43 600 A1 beschreibt eine Vorrichtung mit einer Prozesskammer. Dort ist die Prozesskammer rotationssymmetrisch gestaltet. Durch ein im Zentrum der Decke in einer Prozesskammer angeordnetes Gaseinlassorgan werden mehrere Prozessgase in die Prozesskammer eingeleitet. Dort zerlegen sich die Prozessgase pyrolytisch. Zur Erzeugung der hierzu erforderlichen Temperatur wird zumindest der Boden oder die Decke der Prozesskammer geheizt. Dies kann mit infraroter Strahlung oder mit Hochfrequenz erfolgen.

Der Boden der Prozesskammer besitzt dort eine ringförmige Trägerplatte. Auf der Trägerplatte sitzen einzelne, auf einem Gaspolster mittels Gasströme drehangetriebene Substrathalter. Diese Substrathalter sind in Ausnehmungen der Trägerplatte gelagert. Auf der Trägerplatte liegen auf der die Substrathalter umgebenden Fläche Kompensationsplatten auf.

Der Erfindung liegt die Aufgabe zugrunde, Maßnahmen anzugeben, um in einfacher Weise die Oberflächentemperatur der Kompensationsplatte insbesondere in Strömungsrichtung vor dem Substrathalter an die Prozessbedürfnisse anpassen zu können.

Gelöst wird die Aufgabe durch die in den Ansprüchen angegebene Erfindung. Hierdurch lässt sich auch die Oberflächentemperatur unabhängig von der Trägerplattentemperaturverteilung einstellen. Zur Variierung der Fugenhöhe der Horizontalfuge ist vorgesehen, diese durch Distanzkörper zu definieren. Die Fugenhöhe kann dann durch geeignete Wahl der Distanzkörper eingestellt werden. Zur Halterung der Distanzkörper können Zapfen vorgesehen sein. Beispielsweise können die Zapfen fest mit der Trägerplatte verbunden sein. Auf die Zapfen können dann Distanzscheiben oder Distanzhülsen aufgesetzt werden. Der Zapfen oder die Hülse können in eine Langnut der jeweils anderen Platte eingreifen. Steckt beispielsweise der Zapfen fest in einer Bohrung der Trägerplatte, so kann das freie Ende des Zapfens in eine Langnut der Kompensationsplatte eingreifen. Hierdurch ist eine Kompensation unterschiedliche Wärmeausdehnung von Kompensationsplatte und Trägerplatte möglich. Bevorzugt sind eine Vielzahl von Distanzmitteln vorgesehen. Die Zahl drei ist besonders bevorzugt. Jedes Distanzmittel wird von einem Zapfen gehalten. Jeder Zapfen ragt in eine Langnut ein. Die Langnuten erstrecken sich dabei sternförmig zu einem Zentrum. Örtlich verschiedene Fugenhöhen können dadurch erzeugt werden, dass die Unterseite der Kompensationsplatte geneigt zu ihrer Oberseite verläuft. Dadurch kann sich eine keilförmige Fuge ergeben. Da der Wärmetransport abhängig von der Fugenhöhe ist werden die Bereiche der Kompensationsplatte denen die größte Fugenhöhe zugeordnet ist am schlechtesten mit Wärme versorgt. Demzufolge heizen sich dort die Oberflächenabschnitte weniger stark auf, als Oberflächenbereiche, denen eine geringe Fugenhöhe zugeordnet ist. Bei einer Kompensationsplatte mit geneigt verlaufender Unterseite werden die Distanzkörper vorzugsweise von Distanzhülsen ausgebildet. Die Distanzhülsen stützen sich dabei auf den Böden der Langnuten ab. Diese Böden verlaufen parallel zur Oberseite der Kompensationsplatte. Die Kompensationsplatten können beschichtet sein. Die Beschichtung kann PBN, SiC oder TaC sein. Die Kompensationsplatten können auch aus SiC bestehen. Bevorzugt bestehen sie aus Quarz, Graphit oder beschichtetem Graphit. Die Beschichtung sollte aus einem für die Prozessgase inerten Material bestehen. Es ist von Vorteil, wenn die erfindungsgemäße Vorrichtung eine zentrale Kompensationsplatte aufweist, die an ihrem Rand bogenförmige Aussparungen aufweist. Diese bogenförmigen Ränder bilden eine Fuge zu den drehangetriebenen kreisscheibenförmigen Substrathaltern. Die Trägerplatte kann eine Ringform aufweisen. Im Zentrum des Ringes befinden sich eine Stütz- und eine Zugplatte. Die Stützplatte liegt auf einer Stütze auf. Im Zentrum der Zugplatte greift eine Zugstange an. Betreffend die Ausgestaltung wird auf die Darstellung der DE 100 43 600 A1 verwiesen.

Zufolge der erfindungsgemäßen Ausgestaltung der Vorrichtung kann verhindert werden, dass die Oberflächentemperatur der Kompensationsplatten in der Umgebung des Substrathalter wesentlich höher ist als die Oberflächentemperatur des Substrathalters. Es ist sogar möglich, durch geeignete Wahl der örtlichen Fugenhöhe ein bestimmtes Temperaturprofil einzustellen. In dem die insbesondere beschichteten Kompensationsplatten austauschbar sind, können diese bei der Verwendung von Graphit angreifenden Gase wie bspw. Ammoniak auch in einfacher Weise ausgetauscht werden. Bei veränderten Prozessparametern kann die Anpassung durch Austausch der Distanzmittel erfolgen. Mit der erfindungsgemäßen Vorrichtung lässt sich auch erreichen, dass in einem Planetenreaktor ein Temperaturprofil über dem ringförmige Substratträger eingestellt wird, das von innen nach außen ansteigt. Der Temperaturgradient führt dabei zu keinen Spannungen, die eine Zerstörung der Trägerplatte oder der Kompensationsplatte herbei führen könnte.

Ausführungsbeispiele der Erfindung werden nachfolgend anhand beigefügter Zeichnungen erläutert. Es zeigen:
- Fig. 1: eine Draufsicht auf eine mit mehreren Kompensationsplatten und Substrathaltern bestückte Trägerplatte (die Fugen zwischen den Kompensationsplatten und den Substrathaltern sind zur besseren Erkenntnis übertrieben dargestellt, tatsächlich sollen die Fugen so schmal wie möglich sein),
- Fig. 2: einen Schnitt gemäß der Linie II-II in Fig. 1 durch eine Pro zesskammer,
- Fig. 3: eine vergrößerte Darstellung des Ausschnittes III in Fig. 2,
- Fig. 4: ein Schnitt gemäß der Linie IV-IV in Fig. 3,
- Fig. 5: ein zweites Ausführungsbeispiel der Erfindung dargestellt an einem vergrößerten Ausschnitt etwa gemäß der Linie II-II in Figur 1,
- Fig. 6: ein weiteres Ausführungsbeispiel in einer Darstellung gemäß Fig. 5 und
- Fig. 7: ein weiteres Ausführungsbeispiel der Erfindung in einer Darstellung gemäß Fig. 1.

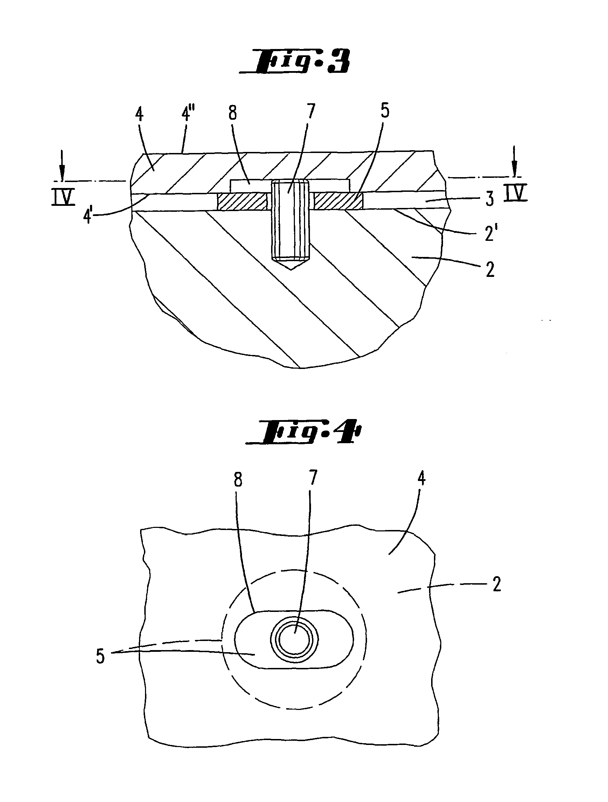

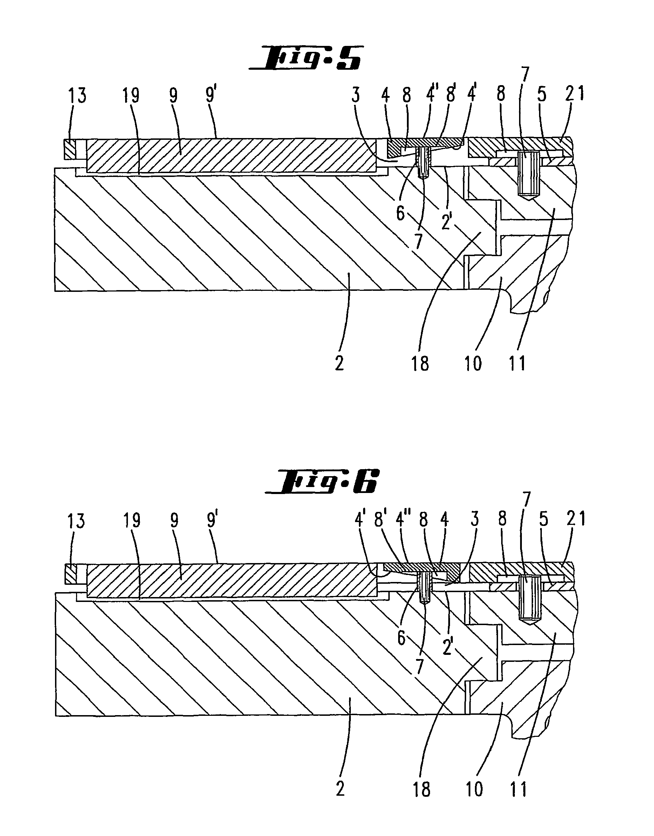

Durch den Einsatz von Kompensationsplatten 4,13, die auf einer Trägerplatte 2 angeordnet sind, lässt sich insbesondere in Richtung des Gasflusses vom Z entrum einer Prozesskammer 1 zum Rand der Prozesskammer 1 vor dem Substrat der Wärmeleitungswiderstand in der Horizontalfuge 3 zwischen der Kompensationsplatte 4 und der Trägerplatte 2 variieren. Damit lässt sich die Temperatur auf der Oberseite 4" der Abdeckplatte 4 unabhängig von der Temperatur der darunterliegenden Trägerplatte 2 variieren. Die Variation des Wärmeleitungswiderstandes wird insbesondere durch den Abstand zwischen Trägerplatte 2 und Kompensationsplatte 4, also die Fugenhöhe der Horizontalfuge 3 ermöglicht. Der Abstand wird durch isolierende Distanzmittel 5,6 definiert. Diese die Form einer oder Scheibe 5 oder einer Hülse 6 aufweisenden Distanzmittel können aus Keramik, Quarz oder Saphir bestehen. Die Horizontalfuge 3 kann gemäß dem in der Figur 3 dargestellten Ausführungsbeispiel eine im Wesentlichen gleichbleibende Tugenhöhe besitzen, die Distanzscheibe 5 liegt dann auf der Oberseite 2" der Trägerplatte 2 auf und trägt die Unterseite 4' der Kompensationsplatte 4. Die Fugenhöhe kann aber auch, wie in den Figuren 5 und 6 dargestellt ist, örtlich variieren. Durch Austausch der Distanzscheiben 5 und Distanzhülsen 6 kann die Fugenhöhe der Horizontalfuge 3 variiert werden.

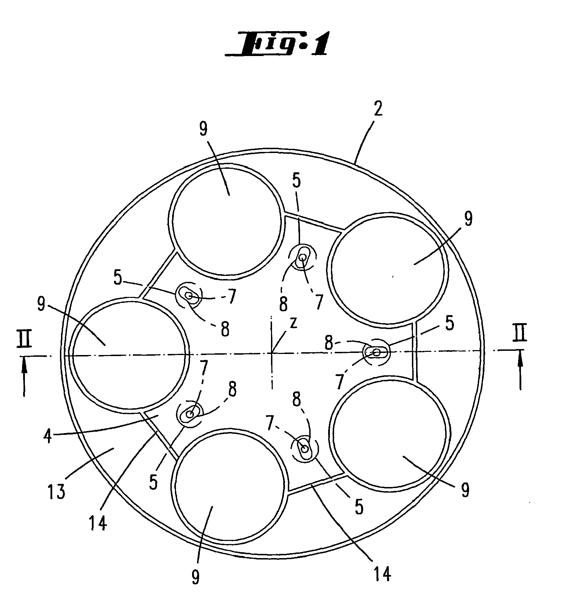

Das in den Figuren 1 bis 4 dargestellte Ausführungsbeispiel besitzt eine rotationssymmetrische Prozesskammer 1. Durch ein lediglich mit der Bezugsziffer 16 angedeutetes Einlassorgan (genaue Ausgestaltung siehe DE 190 43 600) werden Prozessgase mittig in die Prozesskammer eingeleitet. Das Einlassorgan 16 befindet sich im Zentrum der Decke 15 der Prozesskammer L

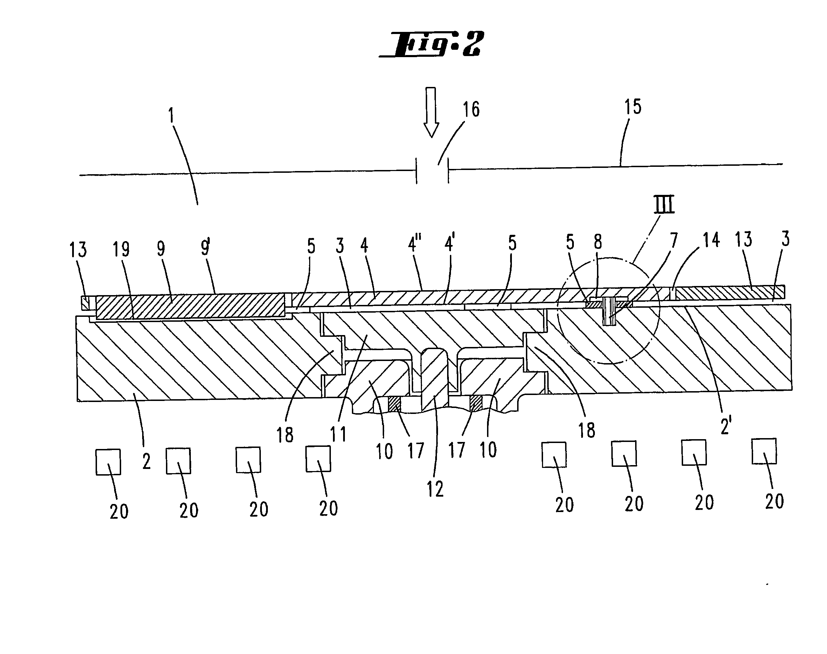

Der Boden der Prozesskammer 1 wird von ringförmig um das Zentrum Z angeordneten Substrathaltern 9 gebildet Auf diesen Substrathaltern 9 können die Substrate aufliegen. Die Zwischenräume zwischen den einzelnen Substrathaltern 9 werden durch Kompensationsplatten 4,13 ausgefüllt. Im Ausführungsbeispiel ist eine zentrale Kompensationsplatte 4 vorgesehen. Im Ausführungsbeispiel gibt es nur eine einzige zentrale Kompensationsplatte 4. Es schließen sich insgesamt fünf periphere Kompensationsplatten 13 an. Wie insbesondere der Figur 2 zu entnehmen ist, erstreckt sich die zentrale Kompensationsplatte 4 unter Ausbildung eines Gasspaltes 3 oberhalb einer ringförmigen Trägerplatte 2. Die Ringaussparung der Trägerplatte 2 wird von einer Zugplatte 11 ausgefüllt. An der Zugplatte 11 greift eine Zugstange 12 an. Der Rand der Zugplatte 11 stützt sich dabei auf einen Kragen 18 der Trägerplatte 2 ab. Der Kragen 18 liegt auf einem Randabschnitt einer Stützplatte 10 auf, die sich parallel zur Zugplatte 11 erstreckt. Die ringförmige Stützplatte 10 stützt sich auf einer Stütze 17 ab.

Unterhalb der aus Graphit bestehenden Trägerplatte 2 befindet sich die Spule 20 einer HF-Heizung, welche die Trägerplatte aufheizt. In der Trägerplatte 2 befinden sich darüber hinaus nicht dargestellte Gaskanäle, durch welche ein Gasstrom fließt, um ein Gaspolster 19 auszubilden, auf welchem die Substrathalter 9 schweben. Der das Gaspolster 19 ausbildende Gasstrom bewirkt zudem eine Eigenrotation der Substrathalter 9. Die Trägerplatte 2 kann um ihre Achse drehangetrieben sein.

Im Bereich zwischen den einzelnen Substrathaltern 9 entspringen der Oberseite 2' der Trägerplatte 2 Zapfen 7. Über die Zapfen 7 sind Distanzscheiben 5 gestülpt. Auf den Distanzscheiben 5 liegt die Unterseite 4' der Kompensationsplatte 4 auf. Die Fugenhöhe der Horizontalfuge 3 ist somit durch die Materialstärke der Distanzscheiben definiert Das über die Oberseite der Distanzscheibe 5 ragende freie Ende des Zapfens 7 ragt in eine der Unterseite 4' der Kompensationsplatte 4 zugeordneten Langnut 8 ein. Die in der Figur 1 dargestellten fünf Langnuten erstrecken sich sternförmig zum Zentrum Z der Kompensationsplatte 4. Es reicht aus, wenn die Kompensationsplatte 4 nur drei Langnuten aufweist Mit diesen drei Langnuten 8 und die zugehörigen Zapfen 7 ist die Lage der Kompensationsplatte 4 zur Trägerplatte 2 definiert. Unterschiedliche Wärmeausdehnungen werden kompensiert.

Bei dem in den Figuren 5 und 6 dargestellten Ausführungsbeispielen ist die unmittelbar in Strömungsrichtung vor den Substrathaltern 9 liegende Kompensationsplatte 4 ringförmig ausgebildet Die Unterseite 4' der ringförmigen Kompensationsplatte 4 verläuft in diesen beiden Ausführungsbeispielen geneigt zur Oberseite 4' bzw. geneigt zur Oberseite 2' der Trägerplatte 2. Hierdurch ergibt sich eine keilförmig Horizontalfuge 3. Die unterschiedliche Fugenhöhe hat einen unterschiedlichen Wärmetransport von der beheizten Trägerplatte 2 zur Kompensationsplatte 4 und damit eine unterschiedliche Oberflächentemperatur der Kompensationsplatte 4 zur Folge. Die Oberseite 4" der Kompensationsplatte 4 und die Oberseite 9' des Substrathalter 9 fluchten vorzugsweise miteinander. Im Innenraum der ringförmigen Kompensationsplatte 4 befindet sich eine Kompensationsplatte 21, die in der oben beschriebenen Weise mittels Distanzhaltern 5 in vertikalem Abstand zur Zugplatte 11 gehalten ist

Die Definition der Höhe der Horizontalfuge 3 wird bei der ringförmigen Kompensationsplatte 4 durch Distanzhülsen 6 erreicht Eine solche, aus einem isolierenden Material bestehende Distanzhülse 6 stützt sich mit ihrem einen Ende auf der Oberseite 2' der Trägerplatte 2 und mit ihrem anderen Ende auf dem Boden 8' der Langnut 8 ab. Der Zapfen 7 durchragt dabei eine zentrale Öffnung der Distanzhülse 6 nur teilweise. Der Boden 8' der Langnut 8 erstreckt sich parallel zur Oberseite 2' der Trägerplatte 2 bzw. parallel zur Oberseite 4" der Kompensationsplatte 4.

Bei dem in Figur 5 dargestellten Ausführungsbeispiel verjüngt sich die Horizontalfuge 3 in Richtung des Gasstromes, also von radial innen nach radial außen. Bei dem in Figur 6 dargestellten Ausführungsbeispiel verjüngt sich die Horizontalfuge 3 von radial außen nach radial innen.

Die peripheren Kompensationsplatten 13 können unmittelbar auf der Oberseite 2' der Trägerplatte 2 aufliegen. Das Material der Kompensationsplatten 4, 13 kann Quarz, SiC oder Graphit sein. Vorzugsweise handelt es sich um TaC- oder SiC- beschichtetes Graphit.

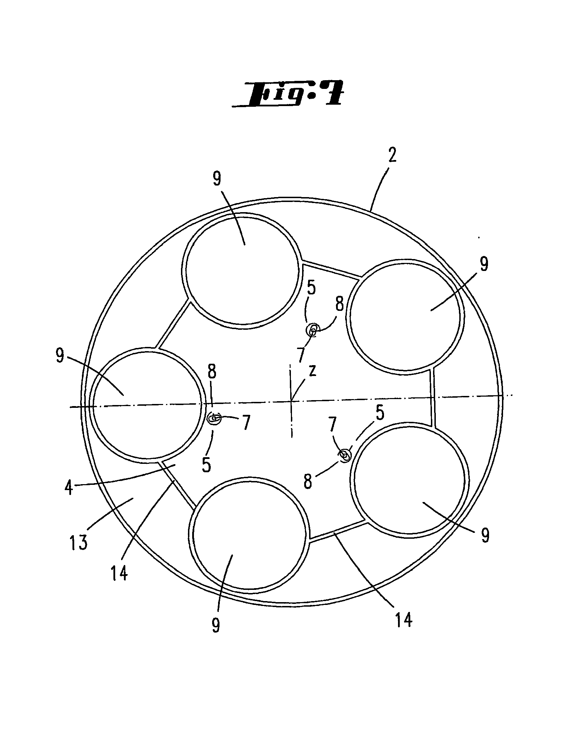

Bei dem in der Fig. 7 dargestellten Ausführungsbeispiel sind nur drei Distanzmittel 5 vorgesehen, die um 120° zum Zentrum winkelversetzt angeordnet sind.

## Patentansprüche

1. Vorrichtung zum Abscheiden von Schichten auf einem oder mehreren Substraten in einer Prozesskammer (1) mittels in die Prozesskammer (1) eingeleiteten und sich dort umsetzenden Reaktionsgasen, mit einer von einer Seite her beheizbaren Trägerplatte (2), auf welcher mindestens ein Substrathalter (9) und mindestens eine diesen umgebene Kompensationsplatte unter Ausbildung einer Horizontalfuge (3) aufliegen, **dadurch gekennzeichnet, dass** in Strömungsrichtung vor dem Substrathalter die Fugenhöhe der Horizontalfuge (3) zur Beeinflussung der örtlichen Oberflächentemperatur der Kompensationsplatte (4) variierbar oder örtlich verschieden ist, wobei die Fugenhöhe durch mindestens einen Distanzkörper (5, 6) definiert ist.

2. Vorrichtung nach Anspruch 1, **dadurch gekennzeichnet, dass** der mindestens eine Distanzkörper als über einen Zapfen (7) gestülpte Scheibe (5) oder Hülse (6) ausgebildet ist.

3. Vorrichtung nach Anspruch 2, **dadurch gekennzeichnet, dass** der fest mit der Trägerplatte (2) oder der Kompensationsplatte (4) verbundene Zapfen (7) oder eine von ihm getragene Hülse (6) in eine Langnut (8) der jeweils anderen Platte eingreift.

4. Vorrichtung nach einem der Ansprüche 2 oder 3, **dadurch gekennzeichnet, dass** eine Vielzahl, bevorzugt drei Zapfen (7) jeweils in eine Langnut (8) eingreifen, wobei die Langnuten (8) auf ein gemeinsames Zentrum (Z) ausgerichtet sind.

5. Vorrichtung nach einem der vorhergehenden Ansprüche, **gekennzeichnet durch** einen keilförmigen Verlauf der Fugenhöhe.

6. Vorrichtung nach Anspruch 5, **dadurch gekennzeichnet, dass** die Unterseite (4') der Kompensationsplatte (4) geneigt zu deren Oberseite (4") verläuft.

7. Vorrichtung nach einem der vorhergehenden Ansprüche, **dadurch gekennzeichnet, dass** der Boden (8') einer der geneigten Unterseite (4') zugeordneten Langnut (8) parallel zur Oberseite (4") der Kompensationsplatte (4) bzw. zur Oberseite (2') der Trägerplatte (2) verläuft.

8. Vorrichtung nach einem der Ansprüche 2 bis 7, **dadurch gekennzeichnet, dass** die von einem der Oberseite (2') der Trägerplatte (2) entspringendem Zapfen (7) getragene Hülse (6) sich auf dem Boden (8') der Langnut (8) abstützt oder eine von dem Zapfen (7) durchgriffene Scheibe (5) den Rand der Langnut (8) abstützt.

9. Vorrichtung nach einem der vorhergehenden Ansprüche, **dadurch gekennzeichnet, dass** die Distanzmittel (5, 6) aus einem Material mit geringer Wärmeleitfähigkeit und/oder hoher Beständigkeit gegen die Prozessgase und/ oder aus Saphir bestehen.

10. Vorrichtung nach einem der vorhergehenden Ansprüche, **dadurch gekennzeichnet, dass** die Kompensationsplatte (4) aus Quarz, SiC oder PBN TaC- oder SiC-beschichteten Graphit besteht.

11. Vorrichtung nach einem der vorhergehenden Ansprüche, **gekennzeichnet durch** eine eine Vielzahl drehbar der Trägerplatte (2) ringförmig zugeordnete Substrathalter (9) teilumfassenden zentrale Kompensationsplatte (4).

12. Vorrichtung nach einem der vorhergehenden Ansprüche, **dadurch gekennzeichnet, dass** die Trägerplatte (4) eine Ringform aufweist und von unten von einer zentralen Stützplatte (10) durch Randuntergriff getragen wird, wobei eine über der Stützplatte (10) liegende Zugplatte (11), an der eine Zugstange (12) angreift, sich auf dem Rand der Trägerplatte (2) abstützt.

13. Vorrichtung nach einem der vorhergehenden Ansprüche, **dadurch gekennzeichnet, dass** die Trägerplatte (2) drehangetrieben ist und die drehbaren Substrathalter (9) jeweils auf einem Gaspolster aufliegend durch das Gaspolster bildende Gasströme drehangetrieben sind.

## Claims

1. Device for depositing of layers on one or more substrates in a process chamber (1) by means of reaction gases that are introduced into the process chamber (1) and undergo in particular pyrolytic reactions there, with a carrier plate (2) which can be heated from one side and on which at least one substrate holder (9) and one compensation plate (4) surrounding the latter rests while forming a horizontal gap (3), wherein upstream of the substrate holder (9) the gap height is variable or locally different, to influence the local surface temperature of the compensation plate (4), whereby the gap height is defined at least by one spacer (5, 6).

2. Device according to claim 1, **characterized in that** the at least one spacer is formed as a disk (5) or sleeve (6) fitted over a pin (7).

3. Device according claim 2, **characterized in that** the pin (7), fixedly connected to the carrier plate (2) or the compensation plate (4), or a sleeve (6) carried by said pin, engages in a slot (8) of the respective other plate.

4. Device according to one of the claims 2 or 3, **characterized in that** a number of pins (7), preferably three, respectively engage in a slot (8), the slots (8) being aligned about a common center (Z).

5. Device according to one of the preceding claims, **characterized by** a wedge-shaped progression of the gap height.

6. Device according to claim 5, **characterized in that** the underside (4') of the compensation plate (4) runs in an inclined manner in relation to its upper side (4").

7. Device according to one of the preceding claims, **characterized in that** the base (8') of a slot (8) associated with the inclined underside (4') runs parallel to the upper side (4") of the compensation plate (4) or the upper side (2') of the carrier plate (2).

8. Device according to one of the claims 2 to 7, **characterized in that** the sleeve (6) carried by a pin (7) extending from the upper side (2') of the carrier plate (2) is supported on the base (8') of the slot (8), or a disk (5) passed through by the pin (7) supports the edge of the slot (8).

9. Device according to one of the preceding claims, **characterized in that** the spacing means (5, 6) consist of a material with low thermal conductivity and/ or high resistance to the process gases and/ or of sapphire.

10. Device according to one of the preceding claims, **characterized in that** the compensation plate (4) consists of quartz, SiC or graphite coated with PBN, TaC or SiC.

11. Device according to one of the preceding claims, **characterized by** a central compensation plate (4) partly enclosing a number of substrate holders (9) rotatably associated with the carrier plate (2) in the form of a ring.

12. Device according to one of the preceding claims, **characterized in that** the carrier plate (4) has the form of a ring and is carried from below by a central supporting plate (10) by engagement under the edge, a tie plate (11) which lies over the supporting plate (10) and on which a tie rod (12) acts being supported on the edge of the carrier plate (2).

13. Device according to one of the preceding claims, **characterized in that** the carrier plate (2) is rotationally driven and the rotatable substrate holders (9) respectively resting on a gas cushion are rotationally driven by streams of gas forming the gas cushion.

## Revendications

1. Dispositif de dépôt de couches sur un ou plusieurs substrats dans une chambre de réaction (1) au moyen de gaz de réaction qui sont introduits dans la chambre de réactions dans laquelle ils sont transformés, ledit dispositif comportant une plaque de support (2) qui peut être chauffée depuis un côté et sur laquelle au moins un porte-substrat (9) et au moins une plaque de compensation entourant ledit substrat sont placés en formant une jonction horizontale (3), **caractérisé en ce que** en amont du porte-substrat par référence à la direction d'écoulement la hauteur de la jonction horizontale (3) est variable ou est localement différente afin d'influer sur la température de surface locale de la plaque de compensation (4), la hauteur de la jonction étant définie par au moins un corps d'écartement (5, 6).

2. Dispositif selon la revendication 1, **caractérisé en ce que** l'au moins un corps d'écartement est conformé en disque (5) ou en manchon (6) embouti sur une cheville (7).

3. Dispositif selon la revendication 2, **caractérisé en ce que** la cheville (7), reliée fixe à la plaque de support (2) ou la plaque de compensation (4), ou un manchon (6) supporté par ladite cheville s'engage dans une gorge longitudinale (8) de l'autre desdites plaques.

4. Dispositif selon l'une des revendications 2 ou 3, **caractérisé en ce qu'**un grand nombre de chevilles (7), de préférence trois, s'engagent chacune dans une gorge longitudinale (8), les gorges longitudinales étant orientées sur un centre commun (Z).

5. Dispositif selon l'une des revendications précédentes, **caractérisé en ce que** la hauteur de la jonction a une allure cunéiforme.

6. Dispositif selon la revendication 5, **caractérisé en ce que** le côté inférieur (4') de la plaque de compensation (4) s'étend obliquement par rapport au côté supérieur (4'') de celle-ci.

7. Dispositif selon l'une des revendications précédentes, **caractérisé en ce que** le fond (8') d'une gorge longitudinale (8) associée au côté inférieur incliné (4') s'étend parallèlement au côté supérieur (4'') de la plaque de compensation (4) ou au côté supérieur (2') de la plaque de support (2).

8. Dispositif selon l'une des revendications 2 à 7, **caractérisé en ce que** le manchon (6) supporté par une cheville (7) saillant du côté supérieur (2') de la plaque de support (2) s'appuie sur le fond (8') de la gorge longitudinale (8) ou un disque (5) traversé par la cheville (7) soutient le bord de la gorge longitudinale (8).

9. Dispositif selon l'une des revendications précédentes, **caractérisé en ce que** les moyens d'écartement (5, 6) sont en un matériau présentant une faible conductivité thermique et/ou une résistance élevée aux gaz de réaction et/ou sont en saphir.

10. Dispositif selon l'une des revendications précédentes, **caractérisé en ce que** la plaque de compensation (4) est en quartz, en SiC ou en graphite recouvert de PBN, de TaC ou de SiC.

11. Dispositif selon l'une des revendications précédentes, **caractérisé par** une plaque de compensation centrale (4) entourant partiellement un grand nombre de porte-substrats (9) associés annulairement et de façon rotative à la plaque de support (2).

12. Dispositif selon l'une des revendications précédentes, **caractérisé en ce que** la plaque de support (4) a une forme annulaire et est porté par en dessous par une plaque de soutien centrale (10) par engagement inférieur au niveau du bord, une plaque de traction (11) se trouvant au-dessus de la plaque de soutien (10) et avec laquelle s'engage une barre de traction (12), s'appuyant sur le bord de la plaque de support (2).

13. Dispositif selon l'une des revendications précédentes, **caractérisé en ce que** la plaque de support (2) est entraînée en rotation et les porte-substrats (9) rotatifs sont entraînés en rotation, en étant placés chacun sur un coussin de gaz, par des flux de gaz formant le coussin de gaz.
